# EUROPEAN PATENT SPECIFICATION

(11) **EP 2 915 899 B1**
(45) Date of publication and mention of the grant of the patent: **15.05.2019**
(21) Application number: 14382080.1
(22) Date of filing: 06.03.2014
(51) Int. Cl.: C23C 14/54, H01J 37/16

(54) **Vacuum vessel and a part of the bounding thereof and a method using it.**
Vakuumgefäß und ein Teil seiner Begrenzung, und dessen Vervendung in einer Methode.
Récipient à vide et une partie de délimitation de celui-ci, ainsi qu'une méthode l'utilisant.

(43) Date of publication of application: 09.09.2015
(73) Proprietor: Consorcio para el diseño, construcción, Equipamiento y explotación del Centro de Láseres Pulsados Ultracortos Ultraintensos, 37185 Villamayor (Salamanca) (ES)
(72) Inventor: Arana Nieto, Diego, 37700 Béjar (Salamanca) (ES); Hernández Toro, Juan, 37188 Salamanca (ES)
(74) Representative: Grünecker Patent- und Rechtsanwälte PartG mbB

(56) References cited:
- LEE S G ET AL: "A vacuum chamber with a radial rotating port", REVIEW OF SCIENTIFIC INSTRUMENTS, AIP, MELVILLE, NY, US, vol. 70, no. 11, 1 November 1999 (1999-11-01), pages 4437-4438, XP012037207, ISSN: 0034-6748, DOI: 10.1063/1.1150091

## Description

The present invention relates to a part of the bounding of a vacuum vessel and a vacuum vessel comprising such a part of the bounding.

### State of the Art

Vacuum vessels are already known from the prior art. They all have in common that several parts of the bounding are bound together, such that they enclose a volume that can be evacuated or at least a differential vacuum, compared to the outside atmosphere, can be applied. Here, a plurality of different devices are known that reduce the pressure within the vacuum vessel to some mbar or to a remaining pressure of 10⁻¹² mbar, which corresponds to extremely high vacuum.

Depending on the actual field in which the vacuum vessel is to be applied, the attainable remaining pressure is of high importance. For example, if a machine intended to work in outer space is to be tested in vacuum, remaining pressures between 10⁻⁷ and 10⁻³ mbar can be sufficient. If, on the other hand, semiconductor materials are to be coated by means of vapor phase evaporation it is preferable that the remaining pressure inside the vacuum chamber be as low as possible (before starting the vapor phase evaporation) in order to avoid contamination of the material that is to be coated.

Known vacuum vessels comprise openings in each, or at least in some of the parts of their bounding, in order to allow for the introduction of materials (for example gas or radiation) into the actual vacuum chamber. Further, output ports are known, especially in view of irradiation experiments, wherein the target is irradiated with a particle beam, thereby emitting secondary particles which are to be detected by means of sensors that are arranged after the respective output port. Once put together, however, it is difficult to rearrange the input ports and output ports in relation to each other without losing the vacuum performance, while carrying out experiments.

### Technical Problem

Considering the above mentioned disadvantages, it is an objective of the present invention to provide more flexible parts of the bounding for vacuum vessels and, also, to provide a vacuum vessel that is flexibly usable.

### Solution

This problem is solved by the bounding part according to independent claim 1 and the vacuum vessel according to independent claim 9. Further, a method for irradiating a target material with a particle beam, within a vacuum vessel, is provided that makes use of the advantages of the part of the bounding and the vacuum vessel. Preferred embodiments are provided in the dependent claims.

The part of the bounding of a vacuum vessel, comprises a fixed wall portion and a movable wall portion, wherein the fixed wall portion comprises a opening and a fixed port, wherein the opening and the fixed port are arranged apart from each other, and the movable wall portion comprises a movable port, wherein the fixed wall portion and the movable wall portion are arranged parallel to one another and the movable wall portion is provided movable relative to the fixed wall portion, such that the movable port is movably arranged in the opening. This allows for flexibly moving the movable port, for example in relation to the fixed port or in relation to a target that might be placed within a vacuum vessel comprising the part of the bounding. Thereby, radiation (for example) being emitted from the target can be flexibly detected without losing the vacuum. The opening may have the form of an elongated strip (hereinafter referred to a strip-type opening) which extends, in the direction in which the movable port can be moved together with the movable wall portion, over an area corresponding to a multiple of the outer extension of the movable port within the strip-type opening in this direction. The opening may extend over the outer extension of the movable port within the opening in the direction perpendicular to the direction in which the movable port can be moved together with the movable wall portion and an additional extension corresponding to a fraction of the outer extension of the movable port in this direction.

The part of the bounding further comprises a second fixed wall portion comprising an opening and a fixed port, wherein the movable wall portion is movably arranged between the first and second fixed wall portions and wherein the openings coincide at least partially with each other and the fixed ports coincide with each other and the movable wall portion is provided movably relative to the first and second fixed wall portions such that the movable port is movably arranged in the openings. By providing the second fixed wall portion, such that the movable wall portion is placed between the first and second fixed wall portions, the movable part is better sealed from the outside of the vacuum chamber, or part of the bounding respectively, thereby ensuring that a movement of the movable wall portion will not result in a complete loss of the vacuum.

Here, it could be advantageous to provide, between the fixed wall portion and the movable wall portion, and between the movable wall portion and the second fixed wall portion, a sealing material such that the openings are completely surrounded by the sealing material. Providing such sealing material can improve the capability of the part of the bounding to maintain the vacuum applied to the vacuum vessel, in which the part of the bounding is applied, when moving the movable wall portion.

In a further embodiment, the sealing comprises an elastomeric material, the elastomeric material being at least one of or comprising at least one of rub flex, neoprene, Teflon, graphite. Those different materials have preferable qualities with respect to their sealing capacities, as well as the friction that is produced when the movable wall portion is moved against the sealing.

Moreover, the part of the bounding can be characterized in that the movable wall portion is movably arranged on a bearing that is arranged fixed with respect to the fixed wall portion, wherein the bearing is an oil free bearing. Providing the movable wall portion on an oil-free bearing provides the advantage of not having to risk degassing of an oil-driven bearing and, therefore, the quality of the applied vacuum can be improved.

In can be provided that the wall portions of the part of the bounding comprise a metal or are made of a metal or are at least partially coated with a metal. Metals provide advantageous qualities with respect to degassing of such wall materials and, therefore, at least coating the used wall material, or even providing the wall portions made of metal or comprising metal can improve the degassing properties of such wall materials and, therefore, the achievable vacuum with a correspondingly equipped vacuum vessel can be improved.

In one embodiment, the part of the bounding is characterized in that the first and second fixed wall portions are cylinder mantles and the movable wall portion is a cylinder mantle section, wherein the openings extend over an angular area of at least 50°, or at least 90°, or at least 180° and the movable wall portion is arranged between the first and second fixed wall portions such that the movable port can be moved over the whole angular area the opening extends over. By allowing for a movement of the movable port over a corresponding angular area, achievable measurement results, for example in view of transmission or reflection experiments, can be significantly improved, as this movable port allows for detecting emitted radiation being emitted from the target over a significant angular area.

Additionally, the part of the bounding may be characterized in that the wall portions are planar, or are cylinder mantle sections being concentrically arranged, or the movable wall portion is a cylinder mantle section and the first and second fixed wall portions are cylinder mantles, wherein the first and second fixed wall portions and the movable wall portion are concentrically arranged. Provision of the part of the bounding as cylinder mantles or cylinder mantle sections can be advantageous as, thereby, the movement of the movable wall portion corresponds to a rotation around the centre axis of the corresponding cylinder and, therefore, the distance between the movable port and a target, being placed in the centre of the vacuum vessel, can be maintained, which will improve the measurement result.

In another embodiment, the movable port is arranged symmetrically with respect to the borders of the movable wall portion and the movable wall portion extends at least over an area that completely covers the opening, wherein the movable wall portion extends, in each direction in which it can be moved, over at least twice the length of the openings. Thereby, it is ensured that the opening is always covered, at least by the movable wall portion, thereby improving the quality of the maintained vacuum while moving the movable wall portion.

According to the invention, a vacuum vessel is provided comprising an upper and a lower lid, wherein, to each of the lids, a bearing is attached, a fixed wall portion, forming a chamber together with the upper and lower lid, and a second fixed wall portion, both being attached concentrically to each other to the lids, a movable wall portion, being movably mounted on the bearings and arranged between and concentrically to the fixed wall portion and the second fixed wall portion, and a first sealing being arranged between the fixed wall portion and the movable wall portion and a second sealing being arranged between the movable wall portion and the second fixed wall portion, the first and second sealing comprising an elastomeric material; wherein the movable wall portion comprises a movable port that is movable together with the movable wall portion; and wherein the fixed wall portion and the second fixed wall portion and the first and second sealing each comprise a opening, wherein the openings coincide at least partially with each other forming an opening in which the movable port is movably arranged, wherein a fixed port is provided extending from the outside of the second fixed wall portion into the chamber. This vacuum vessel allows for moving the movable port without losing the applied vacuum and, therefore, provides significant advantages over known vacuum vessels in view of transmission and reflection experiments, as measurements of transmitted radiation, or reflected radiation, can be carried out under different angles while maintaining the applied vacuum.

The vacuum vessel may be characterized in that the upper and lower lid comprise at least one turbo molecular pump and at least one feed through. By providing the turbo-molecular pump and the respective feed throughs on the lid, these pumps can work irrespective of the movement of the movable wall portion, thereby ensuring that the evacuation of the vacuum vessel can be carried out as usual.

In one embodiment, at least two adapted reductions are provided for the movable port and/or the fixed port, the two adapted reductions having different opening diameters and are adapted to be loosely mountable on the movable port and/or the fixed port. Thereby, the flexible applicability of the vacuum vessel to different applications can be further improved.

It can be advantageous that the vacuum vessel is adapted to be applied in transmission experiments and/or reflection experiments and comprises an internal holder for a target material. A correspondingly equipped vacuum vessel can not only be used in transmission and/or reflection experiments, although this is quite advantageous, but it might also be used in vapor phase evaporation procedures, for example. In general, the provision of the internal holder, together with the adaption of the vacuum vessel to be applied in transmission and reflection experiments, improves the flexibility of the vacuum vessel.

Further, according to the invention, a method for irradiating a target material with a particle beam within a vacuum vessel according to any of the above embodiments or a vacuum vessel comprising a chamber and at least one part of the bounding according to any of the above embodiments is provided, wherein the method comprises placing the target material in the chamber; generating a differential vacuum between the chamber and the outside of the vacuum vessel; generating a particle beam from a particle source; irradiating, through the fixed port, the target material with the particle beam; and moving, while maintaining the chamber under vacuum, the movable port such that at least some of the product particles generated by irradiating the target material with the particle beam, are extracted from the chamber through the movable port. This method provides the advantage of allowing the transmitted or reflected radiation to be detected under different angles during the experiment while, at the same time, maintaining the applied vacuum, which reduces the amount of time required to rearrange components, especially the movable port, of the vacuum vessel when changing specific experiment parameters. The term "particle beam" does not only comprise beams of particles carrying a mass, but, for simplicity, may also comprise lasers. Therefore, whenever the term "particle beam" is used in this application, it may be read as "particle beam and/or laser" or may be considered as also including laser radiation.

The method may further include that the movable port is moved into a measurement position and remains in the measurement position until irradiating the target material with the particle beam has ended, or wherein the movable port is moved while irradiating the target material with the particle beam, and/or wherein the particle beam is a laser pulse or a proton beam or an electron beam and the target material comprises a solid or a liquid. Moving the movable wall portion when not irritating the target material with the particle beam allows for evaluating whether the applied vacuum, after movement of the movable wall portion, is still sufficient to carry out the experiment (irradiating the target with a particle beam) or whether the actual vacuum has to be adjusted due to minor leakages. On the other hand, moving the movable wall portion while irritating the target with the particle beam allows for real time adjustment of the position under which transmitted or reflective radiation is measured. Providing the particle beam as laser pulses or proton beam or electron beam allows for carrying out different transmission and reflection experiments with this method.

### Brief Description of the Drawings

Fig. 1a-d: Schematic depiction of a vacuum vessel according to the invention.
Fig. 2: Top view of the vacuum vessel of Figure 1a.
Figs. 3a-3d: Schematic depiction of different sealings according to some embodiments of the invention.
Fig. 4: Schematic depiction of a vacuum vessel with lids according to the invention.
Fig. 5: Schematic depiction of one further embodiment of a vacuum vessel according to the invention.
Fig. 6 a and b: Schematic depiction of a vacuum vessel according to another embodiment of the invention.

### Detailed Description

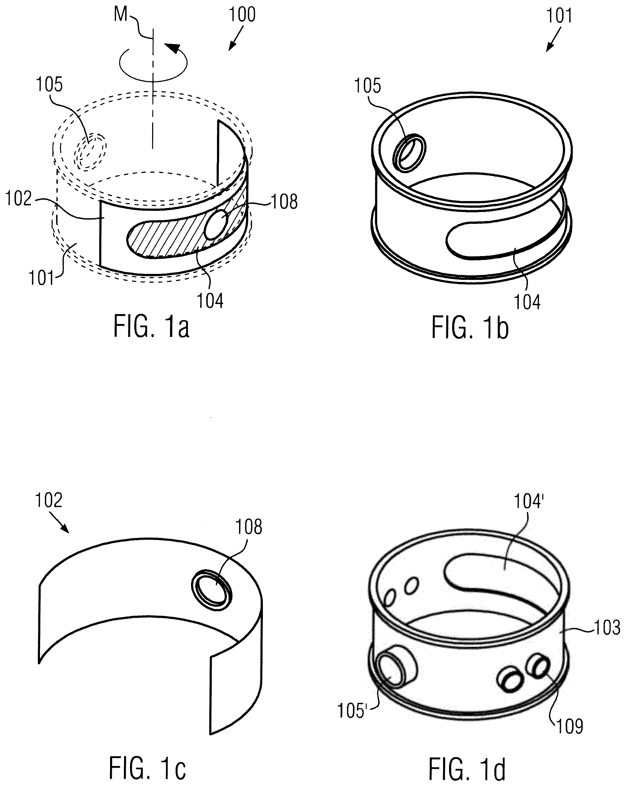

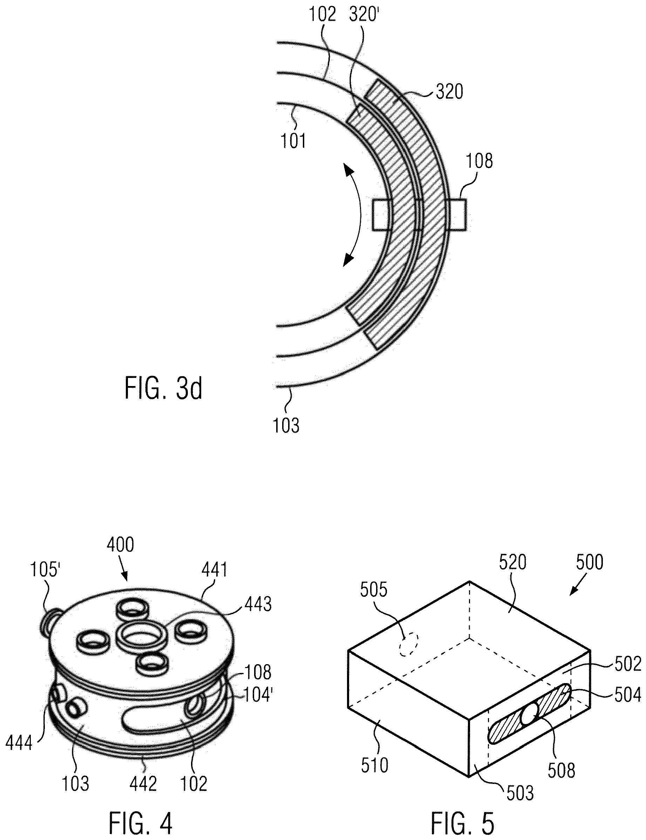

Figure 1a is a schematic depiction of a vacuum vessel 100 according to the present invention. The vacuum vessel 100 may have a cylindrical outer appearance. As will be described with reference to Figure 5, the vacuum vessel does not necessarily have such an outer appearance. The vacuum vessel 100 may also have another shape, such as cuboidal or ellipsoidal (cylinder with elliptic cross-section) or spherical. A part of the bounding of the vacuum vessel includes a fixed wall portion 101. This wall portion 101 may have the shape of a cylinder mantle. It is also possible that the fixed wall portion 101 is only a cylinder mantle section. The fixed wall portion 101 includes an opening 104. Further, the fixed wall portion 101 includes a fixed port 105. This fixed port 105 is preferably arranged on the opposite side of the fixed wall portion with respect to the opening 104. If the fixed wall portion 101 is provided in the form of a cylinder mantle, "opposite side" means that a line that links the fixed port 105 and the centre of the opening 104 includes the centre point M of the vacuum vessel 100. This arrangement, however, is not limiting. The fixed port 105 may also be placed at another point of the fixed wall portion. Throughout the description, the fixed wall portion 101 may also be referred to as a first fixed wall portion in order to distinguish the fixed wall portion 101 from a possibly provided second fixed wall portion. Whenever reference is made to a first fixed wall portion, the fixed wall portion 101 is meant. To support this, the same reference sign will be used for the fixed wall portion and the first fixed wall portion. Although the opening is shown in the figures as a strip-type opening, the opening may be of any shape. For example, the opening may have a circular or rectangular or triangular or elliptic shape. It may also have any irregular shape.

Further, the vacuum vessel 100, or the respective part of the bounding, includes a movable wall portion 102. This movable wall portion 102 comprises a movable port 108. The movable wall portion 102 is arranged, for example, on a bearing within the vacuum vessel, such that the movable port 108 is arranged to coincide with the opening 104 of the fixed wall portion 101. Further, the movable wall portion is arranged such that the movable port can be moved within the opening 104. If the vacuum vessel is provided with a cylindrical outer shape, this movement is, preferably, such that the mobile wall portion 102 rotates around the centre point M or the centre axis of the vacuum vessel 100 that includes the centre point M. Without loss of generality, the fixed port 105 may be considered as a fixed input port, allowing for introducing material into the vacuum vessel, whereas the movable port 108 may be considered as movable output port, allowing for detecting particles escaping, for example, from an irradiated target within the vacuum vessel. It might also be the other way around, i.e. the movable port may be a movable input port, whereas the fixed port may be a fixed output port.

The opening of the fixed wall portion 101 may have the form of an elongated strip (strip-type opening) which extends, in the direction in which the movable port can be moved together with the movable wall portion, over an area corresponding to a multiple of the outer extension of the movable port within the strip-type opening in this direction such that the movable port can be moved over a certain distance. For example, the strip-type opening may extend over 3 times or 5 times the outer extension of the movable port in this direction. In the direction perpendicular to the direction in which the movable port can be moved together with the movable wall portion, the strip-type opening may extend over the outer extension of the movable port 108 within the strip-type opening in this direction and an additional extension corresponding to a fraction of the outer extension of the movable port in this direction. This extension may correspond to 10% or 20% of the outer extension of the movable port 108 in this direction. The extension is, preferably, small in relation to the outer extension of the movable port 108 in this direction and may be provided to ensure that the movable port 108 can be moved within the strip-type opening without being damaged or without damaging the strip-type opening. Thus, the extension may correspond to less than 10%, preferably 5%, most preferred less than 2% of the outer extension of the movable port 108 in this direction. As explained above, the opening may have any shape. The described properties with respect to the strip-type opening may also be provided in respect of other shapes, i.e. the dimensions of the opening may be provided as explained above.

Figure 1b provides a more detailed view of the fixed wall portion 101. As shown in Figure 1b, the fixed wall portion 101 has a cylinder mantle shape. The fixed wall portion may also comprise special connection elements that are only schematically shown here and that are used to connect the fixed wall portion 101 to other fixed, and therefore not movable, parts of the vacuum vessel. It is preferred that the connection of the fixed wall portion to the other parts ensures that, at least along the connection line, the vacuum vessel is sealed such that a vacuum could be generated. The opening 104 of the fixed wall portion 101 may be arranged to extend over an angular area of the cylinder mantle. This angular area may have any arbitrary extent. However, in view of the vacuum vessel being intended to be applicable in transmission and reflection experiments, the opening 104 may extend over at least 45°, preferably 90°, and most preferred 180°. In view of this, it is preferred that the fixed port, through which radiation, for example, can be introduced into the vacuum vessel, is arranged as far away as possible from the opening. Therefore, the fixed port 105, being arranged opposite the centre of the opening, is most preferred, although other realizations can be achieved as well in which the fixed port 105 and the centre of the opening are not arranged on opposite sites. This holds especially for those vacuum vessels that have rectangular outer shape.

Figure 1c shows the movable wall portion 102. In order to ensure that particle beams, for example, can enter the chamber within the vacuum vessel in which a target, for example, can be placed, it is preferred that the movable wall portion 102 has the shape of a cylinder mantle section. The movable port 108 may be arranged in the centre of this cylinder mantle section. As it is intended that the movable port 108 can be moved over the full extent of the opening, it is preferred that the movable wall portion 102 extends in the intended moving direction of the movable port 108, over at least twice the length of the opening. Therefore, it will be ensured that the opening is covered by the movable wall portion at any time and irrespective of the actual position of the movable port 108. This ensures that, during experiments, the applied vacuum can be maintained, even when the movable wall portion, together with the movable port, is moved. In this embodiment, the arrangement of the fixed wall portion and the movable wall portion 102 can be such that, in a radial direction, the fixed wall portion 101 is arranged closer to the centre than the movable wall portion 102. However, it is also possible to choose another arrangement, in which the movable wall portion 102 is arranged closer to the centre of the vacuum vessel than the fixed wall portion 101.

Figure 1d shows an additional fixed wall portion 103. If this second fixed wall portion 103 is provided, then the movable wall portion 102 is arranged between the first fixed wall portion 101 and the second fixed wall portion 103, such that, seen from the centre of the vacuum vessel, the order of the wall portions is as follows: first fixed wall portion 101, movable wall portion 102, and second fixed wall portion 103. In view of Figure 1d, it can be seen that the second fixed wall portion 103 also comprises an opening 104', as well as a fixed port 105'. In this embodiment, the openings 104 of the first fixed wall portion 101 and 104' of the second fixed wall portion 103, as well as the fixed ports 105 and 105', are arranged such that they coincide at least partially or totally with each other, meaning that they extend over the same angular area (with respect to the openings) or are arranged at the same angular position (with respect to the fixed ports) such that, when concentrically arranging the first fixed wall portion 101 and the second fixed wall portion 103, the openings 104 and 104' and the fixed ports 105 and 105' coincide respectively. Further, the second fixed wall portion 103 may comprise, in one embodiment, one or more additional ports 109. These ports can be connected with pumps, for example, in order to keep the space between the movable wall portion 102 and the second fixed wall portion 103 evacuated. Further, other devices, like sensor to measure the remaining pressure within the vacuum vessel, may be connected to the ports 109. The number of ports 109 provided in Fig. 1d may only be seen as an exemplary embodiment. It may be less or even more than 4 ports. In an embodiment, in which only one additional pump and a sensor is connected to the ports 109, two ports may be sufficient, for example.

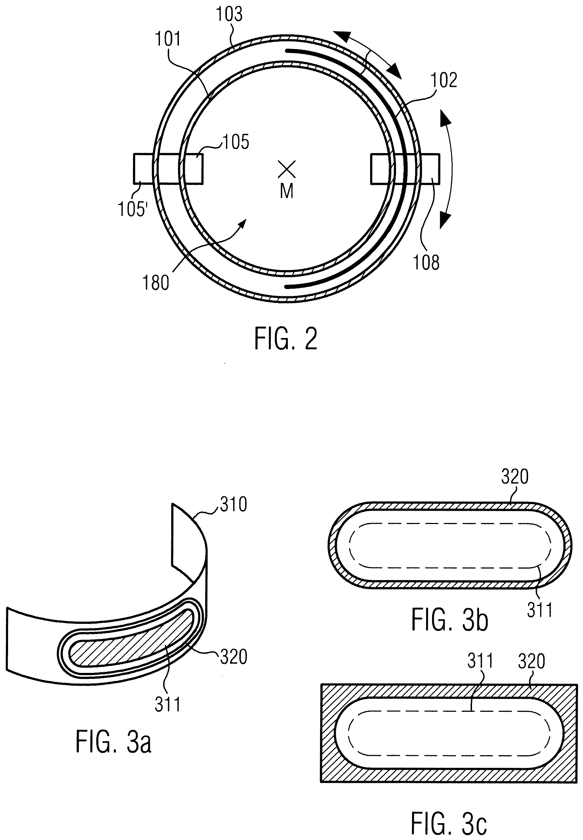

Figure 2 shows a top view schematic depiction of the arrangements of the above-described first fixed wall portion 101, movable wall portion 102, and second fixed wall portion 103. As can be seen in Figure 2, the respective wall portions 101-103 are arranged concentrically around the centre M of the vacuum vessel, thereby, forming part of the boundary of the vacuum vessel. As shown in Figure 2, the fixed ports 105 and 105' may be connected to each other, thereby forming the actual fixed port of the vacuum vessel through which particle beams, for example, can be introduced into the interior 180 of the vacuum vessel, i.e. the actual vacuum chamber. The movable port 108 can be moved together with the movable wall portion 102 along the arrows shown. The movable port preferably extends in the radial direction of the shown arrangement of the first and second fixed wall portions and the movable wall portion, such that it extends further into the interior of the vacuum vessel than the first fixed wall portion 101 and, on the other side, extends further to the outside of the vacuum vessel than the second fixed wall portion 103. This allows for easily modifying, for example, the movable port 108 and ensures that no unintended movement of the movable wall portion 102 can occur perpendicular to the extent of the openings as shown in Figures 1b and 1d.

Figure 3 shows another embodiment of the present invention. In Figure 3a, one of the fixed wall portions (either the first fixed wall portion or the second wall portion) is shown, focusing only on the part of the wall portion that includes the opening 311. In this embodiment, wall portion 310 further includes a sealing 320 that is attached to the fixed wall portion 310. The connection between the fixed wall portion 310 and the sealing 320 is such that preferably no flow of air can occur through this connection. The sealing 320 can be connected to the fixed wall portion either on the side facing away from the centre of the vacuum vessel or on the side facing towards the centre of the vacuum vessel.

In Figures 3b and 3c, different realizations of the sealing 320 are shown. In Figure 3b, the sealing 320 extends in the form on an elongated ring, having an elliptical shape, around the opening 311 of the corresponding fixed wall portion, as described with respect to Figure 3a. The opening 311 is completely surrounded by the sealing 320 while, at the same time, reducing the required amount of sealing material compared to other embodiments. In Figure 3c, the sealing 320 has a rectangular outer shape and comprises an elliptic recess in which the opening 311 is arranged. Providing the sealing in the form of a rectangular shaped piece of material may make it easier to connect the sealing material to the fixed wall portion 310.

The sealing is preferably an elastomeric material like rub flex. When applying a vacuum, this material can expand and, therefore, it can be ensured that gaps between the first fixed wall portion and the movable wall portion, as well as the movable wall portion and the second fixed wall portion, are closed when the movable wall portion is moved relative to the fixed wall portions.

In Figure 3d, a top view of a section of a vessel according to this embodiment is shown. Again, as in Figure 2, the wall portions are arranged such that the movable wall portion 102 extends between the first fixed wall portion 101 and the second fixed wall portion 103. The sealings 320 and 320' are intended to seal the spaces between the wall portions 101 to 103 and, further, to seal the strip-type openings, thereby improving the quality of the vacuum that can be achieved and making it easier to maintain the vacuum, even when the movable wall portion 102 is moved. In an ideal situation, the sealing 320 that is arranged between the movable wall portion 102 and the second fixed wall portion 103, prevents air from the surrounding environment from entering the space between the movable wall portion 102 and the second fixed wall portion 103 through the skip-type opening. As it might be difficult to achieve this to the extent that literally no air from the surrounding environment enters this part of the vacuum vessel, the second sealing 320' may prevent air that nevertheless entered the space between the movable wall portion 102 and the second fixed wall portion 103 from entering the region of the opening of the first fixed wall portion 101. This is advantageous because the bearing in which the movable wall portion 102 may be mounted may not be completely compatible with the vacuum, i.e. due to movable parts, air from the surrounding environment may enter the space between the first fixed wall portion 101 and the movable wall portion 102. By preventing this air from entering the region of the opening of the first fixed wall portion, the vacuum inside the vacuum vessel can be maintained, even when the movable wall portion 102 is moved. It is noted that the opening of the first fixed wall portion 101 is, in this embodiment, directly sealed by means of the movable wall portion itself, which extends over the full width of the opening of the first fixed wall portion 101. As only the movable port 108 allows for exchange of material or gas with the outside of the vacuum vessel, and as this movable port 108 can be sealed or connected to other vacuum-driven devices, direct entry of air through the opening of the first fixed wall portion is prevented. Therefore, the sealings 320 and 320' ensure that preferably no air from the surrounding environment, that could influence on the quality of the vacuum inside the vacuum vessel, enters through the openings.

With respect to the above described sealings, it is noted, that in embodiments of the invention, in which only the fixed wall portion 101 is provided together with the movable wall portion 102, only a sealing between the fixed wall portion and the movable wall portion is provided, i.e. for example only the sealing 320' in Fig. 3d. Even if, in some embodiments, both fixed wall portions, i.e. the first and the second fixed wall portions 101 and 103, are provided, provision of only one sealing, either the sealing 320' or the sealing 320 might be sufficient to maintain the vacuum.

Figure 4 shows a vacuum vessel 400 according to the present invention. This vacuum vessel includes the first and second fixed wall portion (only the second fixed wall portion 103 is shown) and the movable wall portion 102, covering the full width of the opening 104' of the second fixed wall portion 103, as shown. In the opening, the movable port 108 is movably arranged. The vacuum vessel 400 may further include upper and lower lids 441 and 442 which ensure the sealing of the vacuum chamber. It is noted that the first fixed wall portion and the second fixed wall portion 103 may be connected to the upper and lower lids 441 and 442 in a vacuum-compatible way, i.e. the connection via screws, for example, should be such that no air can enter the vacuum chamber through it. In addition to the opening 104' and the fixed port 105', the second fixed wall portion 103 may further include openings 444. These openings can be used to connect the space between the first fixed wall portion, the movable wall portion, and the second fixed wall portion to a differential pump. This pump, or these pumps (depending on how many pumps are connected to the ports 444), may be used to generate a differential vacuum between the actual vacuum chamber and the outside environment of the vacuum vessel. The provided upper and lower lids 441 and 442, may comprise openings 443 that allow for connecting the vacuum chamber to other devices, especially a turbo molecular pump that generates the high vacuum within the vacuum chamber of the vacuum vessel. Thereby, a high or ultrahigh vacuum can be generated in the chamber of the vacuum vessel 400, while ensuring that no air from the surrounding environment enters the vacuum chamber through the openings 104' and the movable wall portion 102, since the differential pumps, which are connected to the space between the first fixed wall portion, the movable wall portion, and the second fixed wall portion 103, through the openings or ports 444, ensure that air from the Surrounding environment, that may enter this space even if the sealing described in Figure 3 is provided, is vacuumed of. In this context, it can be advantageous to only drive the differential pumps connected via the ports 444 if the movable wall portion 102 is indeed moved. When the movable wall portion 102 is not moved, the vacuum can be maintained at high accuracy even without activating the differential pumps connected to the ports 444. Hence, it can be sufficient to just activate these pumps in case the movable wall portion 102 is indeed moved, which may result in air from the surrounding environment entering the vacuum chamber of the vacuum vessel through the openings, perhaps, and the sealings as described with reference to Figure 3.

The vacuum vessel according to the embodiment shown in Figure 4 may be used in transmission or reflection experiments in which a target, placed in the vacuum chamber of the vacuum vessel 400, is irradiated with a particle beam. This particle beam may enter the vacuum chamber through the fixed port 105', the fixed port, therefore, being the fixed input port. This allows for easy and reliable adjustment of the relative position of the target material that may be placed in the centre of the vacuum chamber, and the incident particle beam, as the entrance point of the particle beam is fixed. A corresponding application of the vacuum vessel 400 may, therefore, comprise placing the target material in the vacuum chamber of the vacuum vessel 400 (for example on a holding means). Then, a vacuum has to be applied to the vacuum chamber by driving, for example, the turbo molecular pumps connected to the vacuum chamber and, if necessary, by driving the differential pumps connected to the space between the first fixed wall portion, the movable wall portion, and the second fixed wall portion. When the required vacuum is achieved in the vacuum chamber, the actual experiment may be carried out by irradiating the target material placed in the vacuum chamber with the corresponding particle beam. The corresponding particle beam may originate from a particle beam source not shown, which might be a proton source or an electron source. However, also laser radiation, being emitted from a laser generator, especially a laser pulse generator, may be used as a particle beam. Although laser radiation, or laser pulses, may not be seen as "particles", this radiation is used in this application as one embodiment of a particle beam as well.

While irradiating the target material with the particle beam, secondary particles may be generated, i.e. particles from the target material may be struck out of the target, propagating into corresponding directions which may depend on the orientation of the target surface with respect to the incident particle beam. In order to detect these secondary particles, the movable port 108 of the movable wall portion 102 may be moved together with the movable wall portion within the opening of the first and second fixed wall portions 103. When the particles that are to be detected enter the movable port 108, they can be detected by means of a correspondingly provided detector that is connected to the movable port 108. In this context, the movable port may be considered to be a movable output port. The movement of the movable wall portion 102 together with the movable port 108 may be such that it is moved while maintaining the applied vacuum. This can be achieved by applying a differential vacuum by means of the additional differential pumps connected to the ports 444 when moving the movable wall portion. As it will be of importance for at least some experiments, that the vacuum is maintained throughout the whole experiment, one might carry out the movement of the movable wall portion 102 while not irradiating the target with the particle beam but while maintaining the required vacuum. If the required vacuum cannot be maintained while moving the movable wall portion 102, it can be provided for a latency period after the movement of the movable wall portion 102 has been finished, in which the required vacuum is again reestablished. When the required vacuum is reestablished, the actual experiment can be further carried out, i.e. the target can be irradiated with the particle beam once again. In another embodiment however, the turbo molecular pumps and the differential pump may be adapted to maintain the required vacuum, even while moving the movable wall portion 102. In such a case, the experiment can be continued while moving the movable wall portion, thereby measuring the behaviour of the transmitted or reflected particles in real time, while carrying out the experiment.

Although, for such transmission and reflection experiments, providing the vacuum vessel in the form of a cylinder wherein the target may be placed in the centre of the vacuum chamber may be advantageous, this shape of the vacuum vessel may not be useful for all kinds of experiments. Therefore, Figure 5 shows a further embodiment of the present invention. In this embodiment, the vacuum vessel 500 has a cuboidal outer shape. In such a case, the part of the bounding of the vacuum vessel that comprises the first fixed wall portion, the movable wall portion and, eventually, the second fixed wall portion, may be arranged on one side of the vacuum vessel. In such an embodiment, the first fixed wall portion and the second fixed wall portion may not extend around the complete circumference of the vacuum vessel, as was described, or as was the case, with respect to Figures 1 to 4. However, in this embodiment, the fixed port 505 is preferably arranged on the opposite side of the vacuum vessel with respect to the opening 504 in the fixed wall portion 503. Most preferably, the fixed port 505 is arranged opposite the centre of the opening 504. The movable wall portion 502 may preferably extend over the whole area of the opening in order to ensure that the vacuum can be maintained, or can be approximately maintained, even when moving the movable wall portion 502. Since the fixed wall portion 503 is bound by other parts of the boundary of the vacuum vessel, for example the walls 510 and 520, the movement of the movable wall portion 502 is limited. Therefore, providing for additional stops that strictly limit the movement of the movable wall portion is not necessary.

In view of the above embodiments, it is also noted that it is possible to provide so-called adapted reductions that can be connected to the movable port and/or the fixed port. These adaptive reductions may have different opening diameters, which allows for adjusting the opening diameters of the fixed port and/or the movable port. Preferably, these adaptive reductions are loosely mountable on the movable port and/or the fixed port.

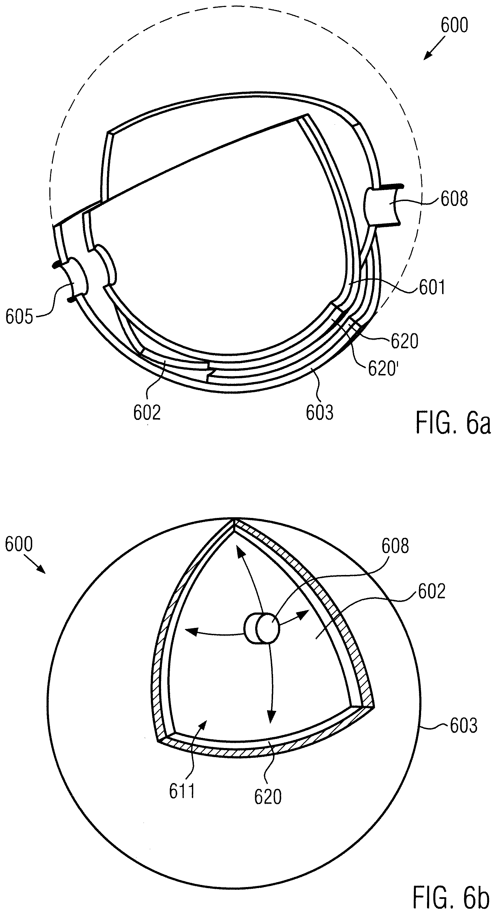

Figures 6a and 6b disclose a further embodiment in which the vacuum vessel 600 has a spherical outer shape. Despite this, it comprises all features that are included in the vacuum vessels described above, i.e. a possibly fixed input port and further ports for connecting differential pumps or other devices. In contrast to the above described vacuum vessels, however, the vacuum chamber itself is not sealed by a fixed wall portion and, in addition to that, an upper and lower lid. Indeed, the surface enclosing the vacuum vessel is provided by the fixed wall portions only. In more detail, the first fixed wall portion 601 encloses the volume of the vacuum chamber inside of the vacuum vessel, whereas the second fixed wall portion 603 forms the outer surface of the vacuum vessel 600. As indicated in Figure 6a, an opening is provided in this embodiment as well, in which a moveable output port 608 can be arranged. The opening, like in the above-described embodiments, is surrounded by sealings 620 and 620', depending on how many fixed wall portions are provided.

Although the moveable output port 608 is arranged together with the moveable wall portion 602, to be moveable within the opening, it is obvious from the spherical outer shape of the vacuum vessel 600 that the moveable output port 608 cannot be moved, together with the moveable wall portion 602, over the whole surface of the vacuum vessel having a spherical outer shape. This is, firstly, because this would mean that neither the first fixed wall portion 601 nor the second fixed wall portion 602 actually would exist since only sections of these fixed wall portions enclose the area in which the moveable output port is moved, i.e. these sections of the first and second fixed wall portions 601 and 603 define the outer shape of the opening. Secondly, if the moveable wall portion, together with the moveable output port 608, were moveable over the complete surface of the spherical vacuum vessel 600, this would mean that there are arrangements in which the fixed input port and the further ports for connecting the vacuum vessel to other devices are covered by the moveable wall portion. This would mean that no material could be input into the vacuum chamber, nor could the vacuum pumps evacuate the vacuum chamber. Hence, the opening may only extend over a limited area of the spherical surface of the vacuum vessel 600.

While this opening may have any shape, as described with reference to the previous embodiments, spherical triangles and rectangles as well as spherical ellipses and circles are preferred. In the embodiment shown in Figure 6b, the vacuum vessel 600 having a spherical outer shape comprises a opening 611 in the form of a spherical triangle. Although the spherical triangle may extend over any area of the spherical vacuum vessel 600, in this embodiment, the opening 611 extends from the "north pole" to the "equator line" of the vacuum vessel 600 and forms an equilateral spherical triangle. Thus, the interior angles are all 90°. However, other embodiments are possible as well, in which the spherical triangle is provided with different side lengths which can be pair-wise disjoined or at least two of them are identical. Further, the sum of the interior angles may have any value between 0<α+β+γ<3π. While, in principle, any of these values are possible, limitations are given in the fact that the input port and the other ports for connecting the vacuum chamber or the vacuum vessel to other devices should, at any time, not be covered by the moveable wall portion 602. Thus, depending on the actual arrangement of these ports and connections, the opening 611 may be limited to a specific form and/or a specific size.

As shown in the embodiment in Figure 6b, the opening 611 in which the moveable wall portion can be seen, and in which the moveable output port 608 can be moved along two dimensions on the surface of the corresponding sphere, is enclosed by the sealing 620. Although perhaps two sealings are provided, one on the side of the second fixed wall portion 603 as shown and one of the side of the first fixed wall portion that is not shown but indicated in Figure 6a, only one sealing is shown here for a better understanding. It is noted that the sealing 620 (and the other sealing 620' as shown in Figure 6a) may be provided in the same way as in the embodiments described above. Providing a vacuum vessel having a spherical outer shape, and allowing the moveable output port to be moved over at least a section of the spherical surface, allows for measuring for example emitted radiation not only in one dimension, but in at least two dimensions in contrast to the previously provided embodiments. Thereby, in this embodiment, other advanced experiments with irradiating targets with particle beams can be carried out and the emitted radiation can be examined.

## Claims

1. Part of a bounding of a vacuum vessel, comprising a fixed wall portion (101) and a movable wall portion (102), wherein the fixed wall portion comprises an opening (104) and a fixed port (105), wherein the opening and the fixed port are arranged apart from each other, and the movable wall portion comprises a movable port (108), wherein the fixed wall portion and the movable wall portion are arranged parallel to each other and the movable wall portion is provided movable relative to the fixed wall portion such that the movable port is movably arranged in the opening wherein the bounding part further comprises a second fixed wall portion (103) comprising an opening (104') and a fixed port (105'), wherein the movable wall portion (102) is movably arranged between the fixed wall portion and the second fixed wall portion and wherein the openings coincide at least partially with each other and the fixed ports coincide with each other and the movable wall portion is provided movably relative to the fixed wall portion and the second fixed wall portion such that the movable port is movably arranged in the openings.

2. Part of a bounding according to claim 1, wherein between the fixed wall portion and the movable wall portion and between the movable wall portion and the second fixed wall portion a sealing material (320') is provided such that the openings are completely surrounded by the sealing material.

3. Part of a bounding according to claim 2, wherein the sealing comprises an elastomeric material, the elastomeric material being at least one of or comprising at least one of rub flex, neoprene, Teflon, graphite.

4. Part of a bounding according to any of claims 1 to 3, wherein the movable wall portion is movably arranged on a bearing that is arranged fixed with respect to the fixed wall portion, wherein the bearing is an oil free bearing.

5. Part of a bounding according to any of claims 1 to 4, wherein the wall portions comprise a metal or are made of a metal or are at least partially coated with a metal.

6. Part of a bounding according to any of claims 1 to 5, wherein the fixed wall portion and the second fixed wall portion are cylinder mantles and the movable wall portion is a cylinder mantle section, wherein the openings extend over an angular area of at least 50°, or at least 90°, or at least 180° and the movable wall portion is arranged between the fixed wall portion and the second fixed wall portion such that the movable port can be moved over the whole angular area the opening extends over.

7. Part of a bounding according to any of claims 1 to 5, wherein the wall portions are planar,
or are cylinder mantle sections being concentrically arranged,
or the movable wall portion is a cylinder mantle section and the fixed wall portion and the second fixed wall portion are cylinder mantles, wherein the fixed wall portion and the second fixed wall portion and the movable wall portion are concentrically arranged.

8. Part of a bounding according to any of claims 1 to 7, wherein the movable port is arranged symmetrically with respect to the borders of the movable wall portion and the movable wall portion extends at least over an area that completely covers the opening, wherein the movable wall portion extends, in each direction in which it can be moved, over at least twice the length of the opening.

9. Vacuum vessel, comprising an upper and a lower lid (441,442) wherein, to each of the lids, a bearing is attached, a fixed wall portion (101), forming a chamber together with the upper and lower lid, and a second fixed wall portion (103), both being attached concentrically to each other to the lids, a movable wall portion (102), being movably mounted on the bearings and arranged between and concentrically to the fixed wall portion and the second fixed wall portion, and a first sealing (320') being arranged between the fixed wall portion and the movable wall portion and a second sealing (320) being arranged between the movable wall portion and the second fixed wall portion, the first and second sealing comprising an elastomeric material;
wherein the movable wall portion comprises a movable port that is movable together with the movable wall portion; and
wherein the fixed wall portion and the second fixed wall portion and the first and second sealing each comprise an opening, wherein the openings coincide at least partially with each other forming an opening in which the movable port is movably arranged,
wherein a fixed port (105) is provided extending from the outside of the second fixed wall portion into the chamber.

10. Vacuum vessel according to claim 9, wherein the upper and lower lid comprise at least one turbo molecular pump and at least one feed through.

11. Vacuum vessel according to claim 9 or 10, wherein at least two adapted reductions are provided for the movable port and/or the fixed port, the two adapted reductions having different opening diameters and are adapted to be loosely mountable on the movable port and/or the fixed port.

12. Vacuum vessel according to any of claims 9 to 11, wherein the vacuum vessel is adapted to be applied in transmission experiments and/or reflection experiments and comprises an internal holder for a target material.

13. Method for irradiating a target material with a particle beam within a vacuum vessel according to any of claims 9 to 12 or a vacuum vessel comprising a chamber and at least one part of a bounding according to any of claims 1 to 8, wherein the method comprises
placing the target material in the chamber;
generating a differential vacuum between the chamber and the outside of the vacuum vessel;
generating a particle beam from a particle source;
irradiating, through the fixed port, the target material with the particle beam;
moving, while maintaining the chamber under vacuum, the movable port such that at least some of the product particles generated by irradiating the target material with the particle beam, are extracted from the chamber through the movable port.

14. Method according to claim 13, wherein the movable port is moved into a measurement position and remains in the measurement position until irradiating the target material with the particle beam has ended
or
wherein the movable port is moved while irradiating the target material with the particle beam
and/or wherein the particle beam is a laser pulse or a proton beam or an electron beam and the target material comprises a solid or a liquid.

## Patentansprüche

1. Teil einer Begrenzung eines Vakuumbehälters, umfassend einen feststehenden Wandabschnitt (101) und einen beweglichen Wandabschnitt (102),
wobei der feststehende Wandabschnitt eine Öffnung (104) und einen feststehenden Anschluss (105) aufweist,
wobei die Öffnung und der feststehende Anschluss voneinander beabstandet angeordnet sind und der bewegliche Wandabschnitt einen beweglichen Anschluss (108) aufweist,
wobei der feststehende Wandabschnitt und der bewegliche Wandabschnitt parallel zueinander angeordnet sind und der bewegliche Wandabschnitt relativ zu dem feststehenden Wandabschnitt beweglich vorgesehen ist, so dass der bewegliche Anschluss beweglich in der Öffnung angeordnet ist,
wobei der Begrenzungsteil weiterhin einen zweiten feststehenden Wandabschnitt (103) umfasst, der eine Öffnung (104') und einen feststehenden Anschluss (105') umfasst,
wobei der bewegliche Wandabschnitt (102) beweglich zwischen dem feststehenden Wandabschnitt und dem zweiten feststehenden Wandabschnitt angeordnet ist und die Öffnungen wenigstens teilweise miteinander übereinstimmen und die feststehenden Anschlüsse miteinander übereinstimmen und der bewegliche Wandabschnitt beweglich zu dem feststehenden Wandabschnitt und dem zweiten feststehenden Wandabschnitt derart vorgesehen ist, dass der bewegliche Anschluss in den Öffnungen beweglich angeordnet ist.

2. Teil einer Begrenzung nach Anspruch 1, bei der zwischen dem feststehenden Wandabschnitt und dem beweglichen Wandabschnitt und zwischen dem beweglichen Wandabschnitt und dem zweiten feststehenden Wandabschnitt ein Dichtungsmaterial (320 ') derart vorgesehen ist, dass die Öffnungen vollständig von dem Dichtungsmaterial umgeben sind.

3. Teil einer Begrenzung nach Anspruch 2, bei der die Dichtung ein Elastomermaterial umfasst, wobei das Elastomermaterial Rub-Flex und/oder Neopren und/oder Teflon und/oder Graphit ist.

4. Teil einer Begrenzung nach einem der Ansprüche 1 bis 3, bei der der bewegliche Wandabschnitt an einem Lager beweglich angeordnet ist, das in Bezug auf den feststehenden Wandabschnitt feststehend angeordnet ist, wobei das Lager ein ölfreies Lager ist.

5. Teil einer Begrenzung nach einem der Ansprüche 1 bis 4, bei der die Wandabschnitte ein Metall umfassen oder aus einem Metall bestehen oder wenigstens teilweise mit einem Metall beschichtet sind.

6. Teil einer Begrenzung nach einem der Ansprüche 1 bis 5, bei der der feststehende Wandabschnitt und der zweite feststehende Wandabschnitt Zylinderummantelungen sind und der bewegliche Wandabschnitt ein Zylindermantelabschnitt ist, wobei sich die Öffnungen über einen Winkelbereich von wenigstens 50° oder wenigstens 90° oder wenigstens 180° erstrecken und der bewegliche Wandabschnitt zwischen dem feststehenden Wandabschnitt und dem zweiten feststehenden Wandabschnitt derart angeordnet ist, dass der bewegliche Anschluss über den gesamten Winkelbereich bewegt werden kann, über den sich die Öffnung erstreckt.

7. Teil einer Begrenzung nach einem der Ansprüche 1 bis 5, bei der die Wandabschnitte eben oder konzentrisch angeordnete Zylindermantelabschnitte sind oder der bewegliche Wandabschnitt ein Zylindermantelabschnitt ist und der feststehende Wandabschnitt und der zweite feststehende Wandabschnitt Zylinderummantelungen sind, wobei der feststehende Wandabschnitt und der zweite feststehende Wandabschnitt und der bewegliche Wandabschnitt konzentrisch angeordnet sind.

8. Teil einer Begrenzung nach einem der Ansprüche 1 bis 7, bei der der bewegliche Anschluss symmetrisch in Bezug auf die Grenzen des beweglichen Wandabschnitts angeordnet ist und der bewegliche Wandabschnitt sich wenigstens über einen Bereich erstreckt, der die Öffnung vollständig bedeckt, wobei sich der bewegliche Wandabschnitt in jede Richtung, in der er bewegt werden kann, über wenigstens die doppelte Länge der Öffnung erstreckt.

9. Vakuumbehälter, umfassend einen oberen und einen unteren Deckel (441, 442), wobei an jedem der Deckel ein Lager angebracht ist, einen feststehenden Wandabschnitt (101), der zusammen mit dem oberen und dem unteren Deckel eine Kammer bildet, und einen zweiten feststehenden Wandabschnitt (103), die beide konzentrisch zueinander an den Deckeln befestigt sind, einen beweglichen Wandabschnitt (102), der beweglich an den Lagern angebracht ist und zwischen dem und konzentrisch zu dem feststehenden Wandabschnitt und dem zweiten feststehenden Wandabschnitt angeordnet ist, und eine erste Dichtung (320'), die zwischen dem feststehenden Wandabschnitt und dem beweglichen Wandabschnitt angeordnet ist, sowie eine zweite Dichtung (320), die zwischen dem beweglichen Wandabschnitt und dem zweiten feststehenden Wandabschnitt angeordnet ist, wobei die erste und die zweite Dichtung ein Elastomermaterial umfassen;
wobei der bewegliche Wandabschnitt eine beweglichen Anschluss aufweist, der zusammen mit dem beweglichen Wandabschnitt bewegbar ist; und
der feststehende Wandabschnitt sowie der zweite feststehende Wandabschnitt und die erste und zweite Dichtung jeweils eine Öffnung aufweisen, wobei die Öffnungen wenigstens teilweise miteinander übereinstimmen und eine Öffnung ausbilden, in der der beweglichen Anschluss beweglich angeordnet ist,
wobei ein fester Anschluss (105) vorgesehen ist, der sich von der Außenseite des zweiten feststehenden Wandabschnitts in die Kammer erstreckt.

10. Vakuumbehälter nach Anspruch 9, bei dem der obere und der untere Deckel wenigstens eine Turbomolekularpumpe und wenigstens eine Durchführung umfassen.

11. Vakuumbehälter nach Anspruch 9 oder 10, bei dem wenigstens zwei angepasste Reduzierstücke für den beweglichen Anschluss und/oder den feststehenden Anschluss vorgesehen sind, wobei die beiden angepassten Reduzierstücke unterschiedliche Öffnungsdurchmesser aufweisen und dazu eingerichtet sind, lose an dem beweglichen Anschluss und dem feststehenden Anschluss angebracht zu werden.

12. Vakuumbehälter nach einem der Ansprüche 9 bis 11, wobei der Vakuumbehälter zur Anwendung in Transmissionsexperimenten und/oder Reflexionsexperimenten eingerichtet ist und einen inneren Halter für ein Targetmaterial umfasst.

13. Verfahren zum Bestrahlen eines Targetmaterials mit einem Teilchenstrahl innerhalb eines Vakuumbehälters nach einem der Ansprüche 9 bis 12 oder eines Vakuumbehälters, der eine Kammer und wenigstens einen Teil einer Begrenzung nach einem der Ansprüche 1 bis 8 umfasst, wobei das Verfahren umfasst:
Plazieren des Targetmaterials in der Kammer;
Erzeugen eines Differenzialvakuums zwischen der Kammer und der Außenseite des Vakuumbehälters;
Erzeugen eines Teilchenstrahls aus einer Teilchenquelle;
Bestrahlen des Targetmaterials mit dem Teilchenstrahl durch den feststehenden Anschluss;
Bewegen der beweglichen Öffnung, während die Kammer unter Vakuum gehalten wird, derart, dass wenigstens einige der Produktteilchen, die durch Bestrahlen des Targetmaterials mit dem Teilchenstrahl erzeugt werden, aus der Kammer durch den beweglichen Anschluss extrahiert werden.

14. Verfahren nach Anspruch 13, bei dem der bewegliche Anschluss in eine Messposition bewegt wird und in der Messposition verbleibt, bis das Bestrahlen des Targetmaterials mit dem Teilchenstrahl beendet ist,
oder der bewegliche Anschluss bewegt wird, während das Targetmaterial mit dem Teilchenstrahl bestrahlt wird,
und/oder der Teilchenstrahl ein Laserimpuls oder ein Protonenstrahl oder ein Elektronenstrahl ist und das Targetmaterial einen Feststoff oder eine Flüssigkeit umfasst.

## Revendications

1. Partie d'une délimitation d'un récipient à vide, comprenant une partie de paroi fixe (101) et une partie de paroi mobile (102), la partie de paroi fixe comprenant une ouverture (104) et un port fixe (105), l'ouverture et le port fixe étant agencés à distance l'un de l'autre, et la partie de paroi mobile comprenant un port mobile (108), la partie de paroi fixe et la partie de paroi mobile étant agencées parallèles l'une à l'autre et la partie de paroi mobile étant fournie mobile par rapport à la partie de paroi fixe de sorte que le port mobile soit agencé mobile dans l'ouverture,
la partie de délimitation comprenant en outre une seconde partie de paroi fixe (103) comprenant une ouverture (104') et un port fixe (105'), la partie de paroi mobile (102) étant agencée mobile entre la partie de paroi fixe et la seconde partie de paroi fixe et les ouvertures coïncidant au moins partiellement l'une avec l'autre et les ports fixes coïncidant l'un avec l'autre et la partie de paroi mobile étant fournie mobile par rapport à la partie de paroi fixe et la seconde partie de paroi fixe de telle sorte que le port mobile soit agencé mobile dans les ouvertures.

2. Partie d'une délimitation selon la revendication 1, dans laquelle un matériau de garniture d'étanchéité (320') se trouve entre la partie de paroi fixe et la partie de paroi mobile et entre la partie de paroi mobile et la seconde partie de paroi fixe de telle sorte que les ouvertures se trouvent complètement entourées par le matériau de garniture d'étanchéité.

3. Partie d'une délimitation selon la revendication 2, dans laquelle la garniture d'étanchéité comprend un matériau élastomère, le matériau élastomère étant au moins l'un ou comprenant au moins l'un parmi du « rub flex », du néoprène, du Teflon, du graphite.

4. Partie d'une délimitation selon l'une quelconque des revendications 1 à 3, dans laquelle la partie de paroi mobile est agencée mobile sur un palier qui est agencé fixe par rapport à la partie de paroi fixe, le palier étant un palier sans huile.

5. Partie d'une délimitation selon l'une quelconque des revendications 1 à 4, dans laquelle les parties de paroi comprennent un métal ou sont constituées d'un métal ou sont au moins partiellement revêtues d'un métal.

6. Partie d'une délimitation selon l'une quelconque des revendications 1 à 5, dans laquelle la partie de paroi fixe et la seconde partie de paroi fixe sont des manchons cylindriques et la partie de paroi mobile est une section de manchon cylindrique, les ouvertures s'étendant sur une aire angulaire d'au moins 50°, ou au moins 90°, ou au moins 180° et la partie de paroi mobile étant agencée entre la partie de paroi fixe et la seconde partie de paroi fixe de telle sorte que le port mobile puisse être déplacé sur la totalité de l'aire angulaire sur laquelle s'étend l'ouverture.

7. Partie d'une délimitation selon l'une quelconque des revendications 1 à 5, dans laquelle les parties de paroi sont planes,
ou sont des sections de manchon cylindrique agencées concentriques,
ou la partie de paroi mobile est une section de manchon cylindrique et la partie de paroi fixe et la seconde partie de paroi fixe sont des manchons cylindriques, la partie de paroi fixe et la seconde partie de paroi fixe et la partie de paroi mobile étant agencées concentriques.

8. Partie d'une délimitation selon l'une quelconque des revendications 1 à 7, dans laquelle le port mobile est agencé symétrique par rapport aux limites de la partie de paroi mobile et la partie de paroi mobile s'étend au moins sur une aire qui couvre complètement l'ouverture, la partie de paroi mobile s'étendant, dans chaque direction dans laquelle elle peut être déplacée, sur au moins deux fois la longueur de l'ouverture.

9. Récipient à vide, comprenant des couvercles supérieur et inférieur (441, 442), un palier étant fixé à chacun des couvercles, une partie de paroi fixe (101), qui forme une chambre avec les couvercles supérieur et inférieur, et une seconde partie de paroi fixe (103), étant toutes deux fixées concentriques l'une à l'autre aux couvercles, une partie de paroi mobile (102) étant montée mobile sur les paliers et agencée entre, et de façon concentrique, la partie de paroi fixe et la seconde partie de paroi fixe, et une première garniture d'étanchéité (320') étant agencée entre la partie de paroi fixe et la partie de paroi mobile et une seconde garniture d'étanchéité (320) étant agencée entre la partie de paroi mobile et la seconde partie de paroi fixe, la première et la seconde garnitures d'étanchéité comprenant un matériau élastomère ;
la partie de paroi mobile comprenant un port mobile qui est mobile conjointement à la partie de paroi mobile ; et
la partie de paroi fixe et la seconde partie de paroi fixe et les première et seconde garnitures d'étanchéité comprenant chacune une ouverture, les ouvertures coïncidant au moins partiellement l'une avec l'autre, ce qui forme une ouverture dans laquelle le port mobile est agencé mobile,
un port fixe (105) étant fourni qui s'étend depuis l'extérieur de la seconde partie de paroi fixe jusque dans la chambre.

10. Récipient à vide selon la revendication 9, dans lequel les couvercles supérieur et inférieur comprennent au moins une pompe turbomoléculaire et au moins une alimentation traversante.

11. Récipient à vide selon la revendication 9 ou 10, dans lequel au moins deux réducteurs adaptés sont fournis pour le port mobile et/ou le port fixe, les deux réducteurs adaptés ayant des diamètres d'ouverture différents et étant adaptés pour pouvoir être montés de façon non serrée sur le port mobile et/ou le port fixe.

12. Récipient à vide selon l'une quelconque des revendications 9 à 11, dans lequel le récipient à vide est adapté pour être mis en oeuvre dans des expériences de transmission et/ou de réflexion et comprend un support intérieur pour un matériau cible.

13. Procédé d'irradiation d'un matériau cible avec un faisceau de particules à l'intérieur d'un récipient à vide selon l'une quelconque des revendications 9 à 12 ou un récipient à vide comprenant une chambre et au moins une partie d'une délimitation selon l'une quelconque des revendications 1 à 8, le procédé comprenant
la mise en place du matériau cible dans la chambre ;
la génération d'un vide différentiel entre la chambre et l'extérieur du récipient à vide ;
la génération d'un faisceau de particules depuis une source de particules ;
l'irradiation, à travers le port fixe, du matériau cible avec le faisceau de particules ;
le déplacement, tout en maintenant la chambre sous vide, du port mobile de telle sorte qu'au moins une partie des particules de produit générées en irradiant le matériau cible avec le faisceau de particules soient extraites de la chambre à travers le port mobile.

14. Procédé selon la revendication 13, dans lequel le port mobile est déplacé dans une position de mesure et demeure dans la position de mesure jusqu'à ce que l'irradiation du matériau cible avec le faisceau de particules soit finie
ou
dans lequel le port mobile est déplacé tout en irradiant le matériau cible avec le faisceau de particules
et/ou dans lequel le faisceau de particules est une impulsion laser ou un faisceau de protons ou un faisceau d'électrons et le matériau cible comprend un solide ou un liquide.
